Europäisches Patentamt

European Patent Office

Office européen des brevets

(11) Publication number: **0 141 538**
**B1**

# (12) EUROPEAN PATENT SPECIFICATION

(45) Date of publication of patent specification: **28.12.88**

(51) Int. Cl.⁴: **H 01 L 29/74,** H 01 L 29/10

(21) Application number: **84306785.1**

(22) Date of filing: **04.10.84**

(54) Static induction thyristor.

(30) Priority: **05.10.83 JP 185112/83**
**20.01.84 JP 7270/84**

(43) Date of publication of application:
**15.05.85 Bulletin 85/20**

(45) Publication of the grant of the patent:
**28.12.88 Bulletin 88/52**

(84) Designated Contracting States:
**CH DE GB LI SE**

(56) References cited:
**EP-A-0 064 561**
**EP-A-0 099 270**
**DE-A-3 002 526**
**DE-A-3 226 327**

(73) Proprietor: **TOYO DENKI SEIZO KABUSHIKI KAISHA**
**No. 7-2 2-Chome Yaesu Chuo-Ku**
**Tokyo 104 (JP)**

(72) Inventor: **Muraoka, Kimihiro**
**1825, Nakato-Cho Totsuka-ku**
**Yokohama City Kanagawa Pref. (JP)**

(74) Representative: **Haggart, John Pawson et al**
**Page, White & Farrer 5 Plough Place New Fetter Lane**
**London EC4A 1HY (GB)**

Courier Press, Leamington Spa, England.

## Description

The present invention relates to a static induction thyristor of the kind comprising a semiconductor substrate having on its opposing main surfaces respective high concentration layers of opposite conductivity types, a cathode electrode provided on one of said surfaces and an anode electrode on the other surface, and buried gate regions in the substrate separated by spaces.

Static induction thyristors of this kind are disclosed in EP—A—0064561 and it is a main object of the present invention to provide an improved static induction thyristor of this kind having a high dv/dt capability immediately after turn-off and in which the gate loss at turn-on under high frequency operation is small. It is a further object to provide a static induction thyristor construction in which the manufacturing yield of the thyristors is improved.

Static induction thyristors are also the subject of DE—A—3002526 which discloses devices comprising buried gate regions and a cathode zone which includes deep regions which protrude downwardly into the channels between the buried gates. In one embodiment the anode comprises $p^+$ regions which overlap the gate regions and are themselves separated by $n^+$ regions.

According to the invention there is provided a static induction thyristor comprising a semiconductor substrate having on its opposing main surfaces respective high concentration layers of opposite conductivity types, a cathode electrode provided on one of said surfaces and an anode electrode on the other surface, and buried gate regions in the substrate separated by spaces, characterised in that the anodic high concentration layer has deep regions which are defined respectively immediately opposite the spaces between the buried gate regions and which either are connected by shallow regions of the anodic layer or are separated by interposed insulating regions of electrically insulating material, said shallow regions or insulating regions being located immediately opposite the buried gate regions.

Some embodiments of the invention will now be described, by way of example, with reference to the accompanying drawings in which:—

Figure 1 is a diagrammatic cross-sectional view of a static induction thyristor according to the invention,

Figure 2 is an equivalent circuit diagram of the static induction thyristor of Figure 1.

Figure 3 is a diagrammatic cross-sectional view of another embodiment of a static induction thyristor according to the invention, and

Figure 4 is another diagrammatic cross-sectional view of a modified embodiment of a static induction thyristor according to the invention.

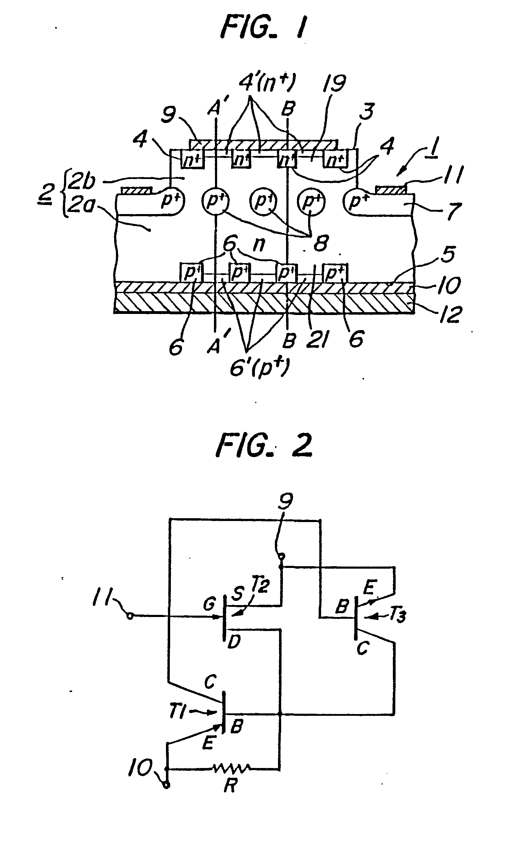

Figure 1 illustrates a static induction thyristor 1 according to the invention, comprising an n type semiconductor substrate 2 having on its opposing main surfaces 3 and 5 respective high concentration layers 4 and 6 of opposite conductivity types. There is a cathode electrode 9, for example of aluminium, on the first high concentration layer 4 which is the cathodic layer.

A gate region 7 is provided on the side of the surface 3 of the semiconductor layer 2 and buried gate regions 8 are embedded in the semiconductor layer 2. In practically manufacturing this thyristor, the $p^+$ gate regions 7 and 8 are formed on an n type substrate 2a by diffusion and an n type epitaxial layer 2b is grown on the substrate 2a to bury the formed $p^+$ gate regions 8. The gate regions 7 and 8 function together as the gate, and are both formed by a diffusion method. Usually the gate area is about 6 to 10 times greater than the channel area.

An anode electrode 10 is provided below the second high concentration layer 6, which is the anodic layer, and a gate electrode 11 is provided on the gate region 7. These 10 and 11 electrodes can also be formed of aluminium.

A supporting electrode 12 is provided below the anode electrode 10 and the electrodes 10 and 12 act together as the anode.

The first high concentration layer comprises deep $n^+$ regions 4 which are separated by interposed shallow $n^+$ regions 4'. For example the deep regions 4 on the line B—B have a junction depth of 10 μm and the shallow regions 4' on the line A'—A' have a junction depth of 1 to 2 μm. The subdivided layer 4, 4' is formed on the surface 3 of the semiconductor layer 2 by a known method such as an oxidized film forming method, a photolithographic method, or the usual diffusion method.

The deep regions 4 and the shallow regions 4' are short-circuited by the cathode electrode 9.

The anodic, high concentration layer is also non-uniform and comprises deep $p^+$ regions 6 which are defined respectively immediately opposite the spaces between the buried gate regions and which are connected by shallow $p^+$ regions 6' of the anodic layer, which shallow regions 6' are located immediately opposite the buried gate regions 8. For example the deep regions 6 on the line B—B have a junction depth of 15 μm, and the shallow regions 6' on the line A'—A' have a junction depth of 1 to 2 μm.

At the regions 19 and 21 of the semiconductor layer 2 located immediately above and below the buried gate region 8 there are thus provided the shallow regions 4' and 6' respectively of the cathodic and anodic high concentration layers.

In the embodiment of Figure 1 the junction depth of the cathodic high concentration layer on the line A'—A' is 1/5—1/10 of the junction depth on the line B—B. In the anodic high concentration layer, the junction depth on the line A'—A' is 1/7—1/15 of the junction depth on the line B—B.

That is, in this construction, there is a $p^+$-n-$p^+$-$n^+$ junction structure on the line A'—A', the first high concentration $n^+$ layer 4' and the second high concentration $p^+$ layer 6' having remarkably shallow junction depth compared with that on line B—B.

In this embodiment at the anode surface 5 of the semiconductor layer 2, the $p^+$ layer 6, the $p^+$ layer 6' and the n layer 21 located immediately below the buried gate region 7, 8 are short circuited by the anode electrode 10.

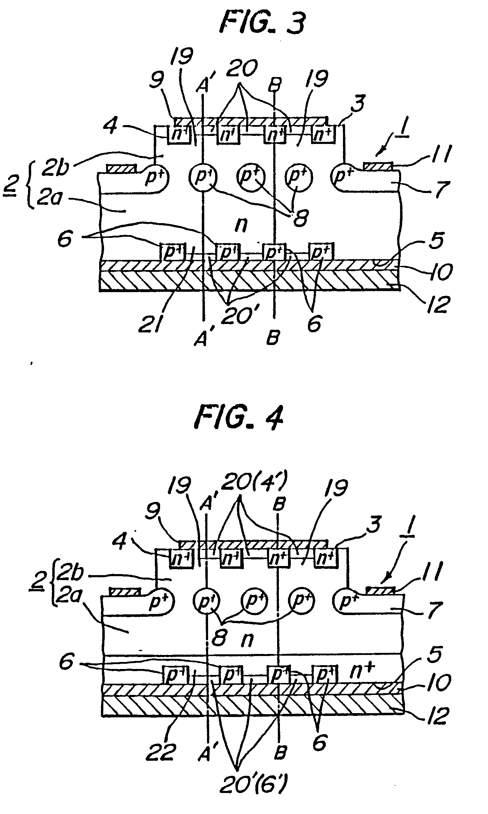

The equivalent circuit diagram of the static induction thyristor of Figure 1 is shown in Figure 2, and comprises a p-n-p transistor $T_1$ and an n-channel static induction transistor $T_2$, having no amplifying function, and of which source S is connected to the cathode electrode 9, gate G is connected to the gate electrode 11 and drain D is connected to base B of the transistor $T_1$. The emitter E of the transistor $T_1$ is connected to the anode electrode 10.

A parasitic n-p-n transistor $T_3$ is connected in parallel with the static induction transistor $T_2$. The transistor $T_3$ has a large gate area and a current amplifying function. A resistor R is connected between the emitter and base of the p-n-p transistor $T_1$.

The ratio of short circuit between the $p^+$ layer 6, the $p^+$ layer 6' and the n layer 21 is about 1, expressed by the surface area of the $p^+$ layer and the n layer at the anode surface.

Accordingly, this thyristor is hardly affected by the influence of the current amplification function since it is formed of a p-n-p transistor $T_1$ having suppressed emitter injection efficiency, and a series connection of the static induction transistor $T_2$ and a parasitic transistor $T_3$ having less emitter injection efficiency. By this reason the dv/dt capability immediately after the turn-off can be made high, and the gate loss at the turn-on of high frequency operation is small.

This embodiment has improved gate-cathode blocking voltage and manufacturing yield.

The formation of the subdivided $p^+$ layer 6 and $p^+$ layer 6' on the anodic side surface 5 in the n layer 2 can also be effected using known methods, for example oxidized film formation, photolithography, or a diffusion technique.

The embodiment shown in Figure 3 is a further improvement on the embodiment shown in Figure 1.

In Figure 3 the deep $n^+$ regions 4 of the cathodic high concentration layer are separated by interposed insulating regions 20 such as oxide films or nitride films provided in the semiconductor layer 2 immediately opposite the buried gate regions 8, that is between the cathode electrode 9 and the region 19 immediately above the buried gate region 8.

The deep regions 6 of the anodic high concentration layer are separated by interposed insulating regions 20' of electrically insulating material which are also located immediately opposite the buried gate regions, and are for example oxide films or nitride films provided in the semiconductor layer 2, between the anode electrode 10 and the region 21 immediately below the buried gate region 8.

By the provision of the insulating layer 20, the current path directly coupling the cathode electrode 9 to the $n^+$ regions 4' of the cathode side surface 3 of the semiconductor layer 2, is electrically interrupted.

Because of the electric insulating function of the insulating layer 20, the blocking voltage between the gate and cathode is further improved, since the formation of the short-circuit between the $n^+$ layer 4 and the $n^+$ layer 4' via the cathode electrode 9 is avoided.

Furthermore, by the insulating action of this insulating layer 20 the operation of the parasitic n-p-n transistor $T_3$ shown in Figure 2 is prevented. The dv/dt capability immediately after the turn-off of this thyristor is much larger than that of a conventional thyristor.

Because of this insulating layer 20, the current path towards the cathode electrode 9 from the buried gate region 8 to the partial region having only a p-n junction is insulated, and thus the current path is substantially limited to that corresponding to the region having only a $p^+$-n-$n^+$ junction. In conventional constructions, no such insulating layer interrupting the current path is provided. Accordingly, the current path in the thyristor of Figure 3 is much narrower than that of a conventional thyristor, and thus the current flowing through the path between the gate and the cathode decreases remarkably. In other words, the resistance between the gate and the cathode of the thyristor becomes high. For this reason, the thyristor of Figure 3 has an advantage in that the gate loss at turn-on under high frequency operation is very small compared with conventional thyristors.

In the embodiment of Figure 3, the occurrence of faults due to defects of the epitaxial growing layer is avoided since the high concentration layer, i.e. the $n^+$ diffusion layer is not provided at the region 19 of the semiconductor layer 2 located immediately above the buried gate region 8 having the gate area substantially larger than the channel area (in practice 1:6—1:10). Instead the insulating layer 20 is provided at the region 19 and electrically inactivated. Thus by the improvement of the gate-cathode blocking voltage, the manufacturing yield can be greatly improved.

In addition in this embodiment, the second high concentration layer, for instance $p^+$ layer 6, is formed with insulating layers 20' at the region 21 immediately below the buried gate regions 8, as viewed from the gate region 8 towards the anodic surface 5 of the semiconductor layer 2, and the $p^+$ layer 6 in the other portions of that surface 5.

In the construction shown in Figure 3, both regions 19 and 21 of the semiconductor layer 2, which are located immediately above and below the buried gate region 8 and are oppositely situated adjacent the cathode electrode 9 and the adjacent anode electrode 10, are not provided with an $n^+$ layer 4 and a $p^+$ layer 6. The cross-sectional structure on the line A'—A' is an n-$p^+$-n junction structure (3 layer transistor structure).

Accordingly, in this embodiment there is no junction having an injecting effect at the region 19 and the region 21 of the semiconductor layer which are located immediately above and below the buried gate region 8. As the result the thyristor, considered in the vertical cross-section, is constructed only from an $n$-$p^+$-$n$ transistor and a $p^+$-$n$-$n^+$ diode. Furthermore, at the anode surface 5 of the semiconductor layer 2, the $p^+$ layer 6 and the $n$ layer 21 are short circuited by the anode electrode. Accordingly, the equivalent circuit diagram becomes as shown in Figure 2.

The short circuit ratio in the area between the $p^+$ layer 6 and the $n$ layer 21 is the ratio of the area of $p^+$ layer to the $n$ layer at the anode surface (area of $p^+$ layer < area of $n$ layer). Accordingly, the short circuit ratio becomes a comparatively large value of about 6 to 10. By contrast the short circuit ratio of $n/p^+$ in conventional thyristors has been less than unity.

Accordingly, as can be seen from the equivalent circuit diagram of Figure 2, this thyristor of Figure 3 consists of a series coupling of a p-n-p transistor $T_1$ having suppressed emitter injection efficiency and a static induction transistor $T_2$. Therefore, this thyristor is hardly affected by the current amplification function, and the dv/dt capability immediately after the turn-off can be made high. Furthermore, the gate loss at the turn-on under high frequency operation is small.

The selective formation of the insulating layer 20, 20' and the selective diffusion can be effected easily by known oxidation techniques, photolithography and etching techniques.

The invention has been explained for n-channel type thyristor, and the invention will have a similar effect when applied with p-channel type thyristor.

Furthermore, as can be seen from Figure 4, the invention can also be applied to a static induction thyristor having a low resistance layer ($n^+$ layer) 22 located between the anode electrode 10 and the $n$ layer 2 in a manner to surround the $p^+$ anodic layer 6 on the anode surface and the invention will have the same effect as with the other embodiments.

The materials used for the formation of each of the regions forming the thyristor and the layers and other parts may be the known materials in this field of technique.

## Claims

1. A static induction thyristor comprising a semiconductor substrate (2) having on its opposing main surfaces (3, 5) respective high concentration layers of opposite conductivity types, a cathode electrode (9) provided on one (3) of said surfaces and an anode electrode (10) on the other surface (5), and buried gate regions (8) in the substrate (2) separated by spaces, characterised in that the anodic high concentration layer has deep regions (6) which are defined respectively immediately opposite the spaces between the buried gate regions (8) and which either are connected by shallow regions (6') of the anodic layer or are separated by interposed insulating regions (20') of electrically insulating material, said shallow regions (6') or insulating regions (20') being located immediately opposite the buried gate regions (8).

2. A static induction thyristor as claimed in Claim 1, including a low resistance layer (22) of opposite conductivity to the buried gate regions (8), which layer (22) is provided between the anodic layer (6) and the substrate (2) to surround the anodic layer (6).

3. A static induction thyristor as claimed in Claim 1 or Claim 2, wherein the deep regions (6) of the anodic layer are directly opposite deep regions (4) of the cathodic layer.

4. A static induction thyristor as claimed in Claim 3, wherein the deep regions (4) of the cathodic layer are separated by interposed insulating regions (20) immediately opposite the buried gate regions (8).

## Patentansprüche

1. Statischer Induktionsthyristor, enthaltend ein Halbleitersubstrat (2), das auf seinen einander gegenüberliegenden Hauptflächen (3, 5) jeweils hoch konzentrierte Schichten von entgegengesetztem Leitfähigkeitstyp aufweist, wobei eine Kathodenelektrode (9) auf einer (3) der genannten Flächen und eine Anodenelektrode (10) auf der anderen Fläche (5) vorgesehen ist, und mit verdeckten Gatebereichen (8) in dem Substrat (2), die durch Abstände getrennt sind, dadurch gekennzeichnet, daß die anodische hoch konzentrierte Schicht tiefe Bereiche (6) aufweist, die jeweils unmittelbar gegenüber den Abständen zwischen den verdeckten Gatebereichen (8) begrenzt sind und die jeweils durch flache Bereiche (6') der anodischen Schicht verbunden sind oder durch zwischenliegende Isolierbereiche (20') aus elektrisch isolierendem Material getrennt sind, wobei die flachen Bereiche (6') oder isolierenden Bereiche (20') unmittelbar gegenüber den verdeckten Gatebereichen (8) angeordnet sind.

2. Statischer Induktionsthyristor nach Anspruch 1, enthaltend eine Schicht (22) niedrigen Widerstands von zu den verdeckten Gatebereichen (8) entgegengesetzter Leitfähigkeit, welche Schicht (22) zwischen der anodischen Schicht (6) und dem Substrat (2) vorgesehen ist, um die anodische Schicht (6) zu umgeben.

3. Statischer Induktionsthyristor nach Anspruch 1 oder 2, bei dem die tiefen Bereiche (6) der anodischen Schicht direkt gegenüber tiefen Bereichen (4) der kathodischen Schicht liegen.

4. Statischer Induktionsthyristor nach Anspruch 3, bei dem die tiefen Bereiche (4) der kathodischen Schicht durch zwischenliegende isolierende Bereiche (20) unmittelbar gegenüber den verdeckten Gatebereichen (8) getrennt sind.

## Revendications

1. Thyristor à induction statique comprenant un substrat semiconducteur (2) ayant sur ses deux surfaces opposées principales (3, 5) des couches de concentration élevée de conductivité de type opposé, une électrode cathodique (9) disposée sur une desdites surfaces (3) et une électrode anodique (10) sur l'autre surface (5), et des régions de gachette enterrées (8) dans le substrat (2) et séparées par des espaces, caractérisé en ce que la couche à haute concentration anodique a des régions profondes (6) qui sont situées immédiatement en face des espaces entre les régions de gachette enterrées (8) et qui sont soit connectées par des régions peu profondes (6') de la couche anodique, soit séparées par des régions isolantes intercalaires (20') d'un matériau électriquement isolant, lesdites régions peu profondes (6') ou lesdites régions isolantes (20') étant situées immédiatement en face des régions de gachette enterrée (8).

2. Thyristor à induction statique selon la revendication 1, comportant une couche à faible résistance (22) de conductivité opposée à celle des régions de gachette enterrées (8), laquelle couche (22) est située entre la couche anodique (6) et le substrat (2) pour entourer la couche anodique (6).

3. Thyristor à induction statique selon la revendication 1 ou la revendication 2, où les régions profondes (6) de la couche anodique sont directement en face des régions profondes (4) de la couche cathodique.

4. Thyristor à induction statique selon la revendication 3, où les régions profondes (4) de la couche cathodique sont séparées par des régions isolantes intercalaires (20) immédiatement en face des régions de gachette enterrées (8).

FIG. 1

FIG. 2

## FIG. 3

## FIG. 4